(19) Europäisches Patentamt

European Patent Office

Office européen des brevets

(11) **EP 2 158 494 B1**

(12) **FASCICULE DE BREVET EUROPEEN**

(45) Date de publication et mention de la délivrance du brevet:
**13.04.2016 Bulletin 2016/15**

(21) Numéro de dépôt: **08806043.9**

(22) Date de dépôt: **19.06.2008**

(51) Int Cl.:
*G01R 29/24* *(2006.01)*      *G01R 31/00* *(2006.01)*
*G01R 31/12* *(2006.01)*

(86) Numéro de dépôt international:
**PCT/FR2008/051109**

(87) Numéro de publication internationale:
**WO 2009/004259 (08.01.2009 Gazette 2009/02)**

(54) **DISPOSITIF POUR DETERMINER UNE REPARTITION DE CHARGES DANS UN ELEMENT DIELECTRIQUE**

EINRICHTUNG ZUR BESTIMMUNG EINER LADUNGSVERTEILUNG IN EINEM DIELEKTRISCHEN ELEMENT

DEVICE FOR DETERMINING A CHARGE DISTRIBUTION IN A DIELECTRIC ELEMENT

(84) Etats contractants désignés:
**AT BE BG CH CY CZ DE DK EE ES FI FR GB GR HR HU IE IS IT LI LT LU LV MC MT NL NO PL PT RO SE SI SK TR**

(30) Priorité: **20.06.2007   FR 0704393**

(43) Date de publication de la demande:
**03.03.2010   Bulletin 2010/09**

(73) Titulaire: **Centre National d'Etudes Spatiales 75001 Paris (FR)**

(72) Inventeur: **PAYAN, Denis F-31320 Mervilla (FR)**

(74) Mandataire: **Blot, Philippe Robert Emile et al Cabinet Lavoix
2, place d'Estienne d'Orves
75441 Paris Cedex 09 (FR)**

(56) Documents cités:
• **FUKUNAGA K: "Innovative PEA space charge measurement systems for industrial applications" IEEE ELECTRICAL INSULATION MAGAZINE, IEEE SERVICE CENTER, NEW YORK, NY, US, vol. 20, no. 2, mars 2004 (2004-03), pages 18-26, XP011110536 ISSN: 0883-7554 cité dans la demande**

**Description**

L'invention se rapporte à un dispositif pour déterminer une répartition de charges contenues dans l'épaisseur d'un élément réalisé dans un matériau diélectrique.

L'invention vise en particulier à étudier les charges réparties dans l'épaisseur d'un élément diélectrique irradié, de sorte à anticiper le comportement de l'élément dans un environnement spatial.

Les matériaux diélectriques sont notamment utilisés comme revêtement des satellites ou autre engin spatial, de manière à protéger l'électronique qu'ils enferment.

L'environnement spatial est constitué d'un plasma comportant des charges électrostatiques qui tendent à s'accumuler en surface des matériaux diélectriques recouvrant des engins placés en orbite stationnaire. Au-delà d'un seuil de quantité de charges accumulées dans le revêtement diélectrique, il se crée notamment des phénomènes de décharges électrostatiques (ou « flashover ») en surface ou dans le volume du matériau diélectrique, ces décharges étant à l'origine de perturbations dans le fonctionnement des engins spatiaux.

Il est actuellement impossible d'étudier ces phénomènes dans l'environnement spatial réel, ni même d'y étudier le comportement du matériau diélectrique stockant ces charges.

On a donc cherché à reproduire l'environnement spatial en laboratoire. Pour ce faire, les éléments réalisés dans un matériau diélectrique sont soumis à un plasma dont les caractéristiques sont maîtrisées, et le comportement de tels éléments est étudié.

Différents dispositifs d'analyse de répartition de charges dans l'épaisseur des éléments ont été mis au point. Certains de ces dispositifs permettent d'appliquer une méthode dite « électro-acoustique pulsée » (ou « méthode PEA »), qui vise à déterminer la densité, la répartition et la polarité des charges contenues dans l'élément à analyser.

Le principe de la méthode PEA consiste à appliquer une impulsion de courte durée sur un élément placé entre deux électrodes, dans le but de sonder le matériau. Sous l'effet de l'impulsion électrique initiale, les charges contenues dans le matériau se déplacent parallèlement au champ électrique produit et reviennent à leur position initiale. Ce déplacement de charges génère une onde électroacoustique qui se propage dans la direction du champ. Cette onde, dont l'amplitude est proportionnelle à la quantité de charges contenues ou induites sur les électrodes, se dirige vers la surface de l'élément analysé à une vitesse qui est propre au matériau dans lequel est réalisé l'élément analysé. La profondeur des charges dans l'élément est déduite de cette vitesse. L'électrode réceptrice est équipée d'un capteur piézo-électrique qui transforme l'onde acoustique en signal électrique. Ce dernier est amplifié et transmis à un oscilloscope de mesure qui permet de visualiser le signal. Un système de traitement de données du signal électrique, associé à un logiciel et renseigné avec une mesure de référence, délivre alors des informations concernant la distribution spatiale des charges contenues dans l'élément analysé.

Une telle méthode est notamment décrite dans l'article intitulé « INNOVATIVE PEA SPACE CHARGE MEASUREMENT SYSTEMS FOR INDUSTRIAL APPLICATIONS » (IEEE Electrical Insulation Magazine, March/April 2004-Vol. 20, No2).

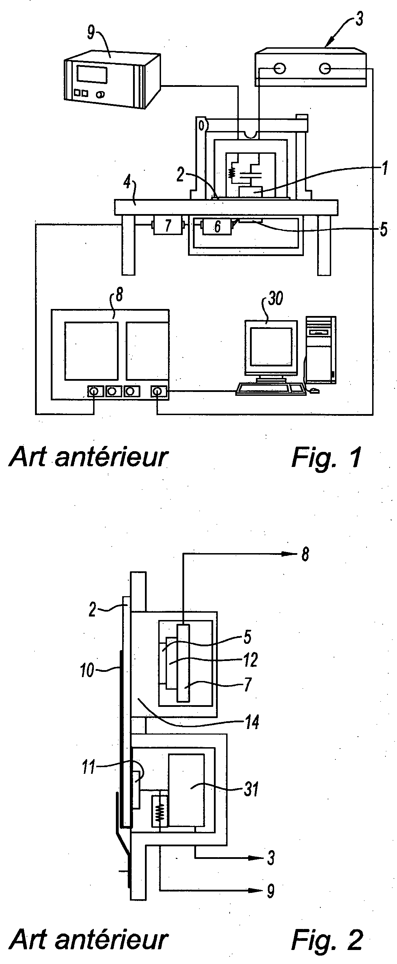

Un dispositif permettant de mettre en oeuvre cette méthode PEA est illustré schématiquement en figure 1.

Il comporte une électrode 1 émettrice d'une impulsion dans un élément 2 à analyser, l'élément étant réalisé dans un matériau diélectrique, l'electrode 1 étant reliée à un générateur 3 de l'impulsion, apte à générer une onde acoustique traversant l'élément 2. Le dispositif comporte également un support apte à supporter l'élément 2 à analyser, ledit support étant relié à une électrode réceptrice 4, équipée d'un capteur piézo-électrique 5 apte à capter l'onde acoustique générée par l'impulsion et à la transformer en signal électrique pour matérialiser l'onde générée par l'impulsion sur un oscilloscope, de sorte à analyser la répartition géographique des charges stockées.

Le dispositif comporte également des amplificateurs 6 et 7 disposés en sortie du capteur, assurant l'amplification du signal de manière à pouvoir l'analyser et le visualiser sur un oscilloscope 8 disposé en aval. Enfin, l'électrode émettrice 1 est alimentée en tension par une alimentation 9.

Un ordinateur 30 est relié d'une part à l'oscilloscope 8 pour recevoir le signal électrique et analyser les données qu'il comporte. L'ordinateur 30 est d'autre part relié au générateur d'impulsion 3 de sorte à être informé des paramètres de l'impulsion initiale transmise par l'électrode émettrice. On peut ainsi déterminer la répartition des charges stockées dans ledit élément et visualiser les résultats sous forme de tableaux ou de représentation en trois dimensions, via l'écran de l'ordinateur.

Un tel dispositif présente l'inconvénient de présenter des résultats imprécis, voire altérés, qui ne représentent pas la quantité réelle de charges contenues dans l'élément, et en particulier lorsque l'élément présente une faible épaisseur (c'est-à-dire de l'ordre de 0 à 500 $\mu$m). En effet, quand l'électrode émettrice est mise en contact avec l'élément, il se crée des décharges électrostatiques. Ce phénomène est du en partie à la faible épaisseur de l'élément : au moment où l'électrode émettrice entre en contact avec le matériau, les charges sont fortement attirées vers l'électrode émettrice. Ainsi, au lieu d'osciller entre deux positions, les charges sont extirpées par l'électrode émettrice. Seules les charges disposées plus en profondeur dans l'élément sont réellement détectées.

Pour pallier cet inconvénient, un autre dispositif, illustré en figure 2, a été proposé. Un tel dispositif est également décrit dans le document mentionné ci-dessus.

Suivant ce dispositif, une fine couche métallique 10 conductrice est appliquée en surface de l'élément à analyser 2, et constitue une couche conductrice apte à amener une impulsion jusqu'en surface de l'élément à analyser. Sur l'autre surface de l'élément à analyser 2, sont disposées deux électrodes 11 et 14 respectivement émettrice et réceptrice. L'électrice émettrice 11 est reliée à la couche métallique ainsi que, d'une part, à un générateur d'impulsion 3 par l'intermédiaire d'un circuit électronique 31 dont l'impédance correspond à celle souhaitée au niveau de l'électrode émettrice, et d'autre part à une alimentation en tension 9. L'électrode réceptrice 14 comporte un capteur piézo-électrique 5 et est reliée à un filtre 12 (retrait des courants polluants), suivi d'un amplificateur 7. Ce dernier est relié à un oscilloscope 8 et est alimenté au moyen d'une alimentation en tension non représentée.

L'avantage de disposer les électrodes du même côté de l'élément à analyser est de pouvoir irradier un côté de l'élément sans avoir à débrancher l'une ou l'autre des électrodes.

Toutefois, un tel dispositif présente l'inconvénient d'être à l'origine d'un phénomène de réflexion de l'onde acoustique générée par l'impulsion, ce qui rend les résultats difficiles à analyser.

L'invention a pour objectif de pallier les inconvénients des dispositifs présentés ci-dessus.

Elle concerne un dispositif pour déterminer une répartition de charges stockées dans un élément réalisé en matériau diélectrique, ledit dispositif comprenant, de manière en soit connue :

- une électrode émettrice d'une impulsion apte à générer une onde acoustique par déplacement desdites charges stockées dans ledit élément, ladite électrode émettrice étant reliée à un générateur de ladite impulsion,
- et une électrode réceptrice connectée audit élément et équipée d'un capteur apte à détecter ladite onde acoustique et à la transformer en signal électrique, de sorte à déterminer la répartition des charges stockées dans ledit élément à partir dudit signal électrique.

Conformément à l'invention, l'électrode émettrice est une électrode sans contact avec ledit élément stockant lesdites charges, apte à transmettre ladite impulsion audit élément à travers un diélectrique séparant ladite électrode émettrice dudit élément, par effet de ligne.

On comprendra par « effet de ligne » ou « effet de ligne de transmission » la transmission d'un signal électrique (ou d'une impulsion électrique) entre deux éléments, l'un conducteur (élément métallique), et l'autre formant masse. Les deux éléments sont placés en regard l'un de l'autre et séparés par un diélectrique. Ils forment une capacité et leur longueur forme une inductance. La propagation du signal à faible perte entre l'élément conducteur et l'élément formant masse est possible si le rapport inductance sur capacité (L/C) donne une impédance caractéristique constante le long du trajet de l'impulsion.

Ainsi réalisé, le dispositif selon l'invention permet d'irradier un élément à analyser et d'analyser cet élément, même s'il présente une faible épaisseur, avec des électrodes et en appliquant la méthode PEA, sans générer de décharge électrostatique entre l'électrode émettrice et l'élément chargé.

Par ailleurs, l'invention ne nécessite pas d'avoir à préparer l'échantillon, comme par exemple dans le mode de réalisation illustré en figure 2 où une couche mince métallique doit être préalablernent déposée sur l'échantillon.

En outre, ainsi réalisé, le dispositif selon l'invention permet de détecter jusqu'à 75 % des charges théoriquement réparties dans le matériau irradié, alors que les dispositifs de l'art antérieur détectent seulement environ 10 % des charges théoriquement réparties dans l'élément analysé.

Suivant certains modes de réalisation, le dispositif selon l'invention comporte une ou plusieurs des caractéristiques suivantes, prises seules ou en combinaison.

On peut par exemple prévoir que l'électrode sans contact soit une ligne micro ruban. Un tel mode de réalisation présente l'avantage d'être aisément mis en oeuvre, puisque les lignes micro ruban présentent de nombreuses applications dans le domaine de l'électronique et qu'elles sont facilement réalisables.

Dans le cadre de ce mode de réalisation, il est avantageux que la ligne micro ruban présente une impédance sensiblement égale à 50 $\Omega$. Avec un dispositif ainsi réalisé, le signal émis n'est pas déformé.

On peut, par ailleurs, prévoir que l'électrode émettrice soit montée amovible, ce qui permet, si on le souhaite, de pouvoir retirer l'électrode pendant l'irradiation de l'élément à analyser.

De manière à maintenir à distance constante l'électrode émettrice de l'élément à analyser, l'électrode émettrice est fixée à un dispositif de maintien à distance dudit élément. Cela présente l'avantage de pouvoir renouveler l'analyse de l'échantillon en garantissant que les conditions d'émission du signal à partir de l'électrode émettrice soient identiques d'une analyse à l'autre.

Afin d'éviter un retour de signal qui pourrait être perturbateur dans l'analyse de la répartition des charges, il peut avantageusement être prévu de relier l'une des extrémités de l'électrode émettrice au générateur d'impulsion et l'autre extrémité de l'électrode émettrice à une charge dont l'impédance est égale à la sienne.

Enfin, et pour faciliter les conditions de mise en oeuvre du dispositif selon l'invention, il peut être prévu que le diélectrique soit de l'air ou du vide.

Suivant un autre aspect, l'invention concerne un procédé d'analyse d'une répartition de charges stockées dans un élément réalisé en matériau diélectrique, ledit procédé comportant les étapes suivantes :

- émission d'une impulsion électrique apte à générer une onde acoustique par déplacement desdites charges stockées dans ledit élément au moyen d'une électrode émettrice reliée à un générateur d'impulsion,
- détection de ladite onde acoustique au moyen d'une électrode de réception,
- transformation de ladite onde acoustique en signal électrique au moyen d'un capteur piézoélectrique relié à l'électrode de réception,
- détermination de la répartition des charges stockées dans ledit élément à partir du signal électrique.

Conformément à l'invention, ladite étape d'émission est réalisée à distance dudit élément, par effet de ligne, au moyen d'une électrode sans contact avec ledit élément stockant lesdites charges, un diélectrique séparant ladite électrode émettrice dudit élément.

Suivant un mode de mise en oeuvre du procédé selon l'invention, une ou plusieurs des caractéristiques suivantes peuvent être appliquées seules ou en combinaison :

- l'électrode sans contact présente une impédance sensiblement égale à 50 $\Omega$ ;
- le diélectrique est de l'air ;
- on applique une charge dont l'impédance est égale à l'impédance de ladite électrode sans contact à une extrémité de l'électrode émettrice, l'autre extrémité de l'électrode émettrice étant reliée au générateur d'impulsion ;
- on contrôle ladite impulsion au moyen d'un oscilloscope connecté à l'une des extrémités de l'électrode sans contact, l'autre extrémité de l'électrode sans contact étant reliée au générateur d'impulsion ;
- on atténué l'amplitude de l'impulsion en amont de l'oscilloscope relié à une extrémité de l'électrode sans contact ;
- on réalise une irradiation du matériau avant l'étape d'émission de l'impulsion ;
- l'impulsion émise est du type tension en créneaux.

D'autres caractéristiques et avantages de l'invention apparaîtront dans la description d'un mode de réalisation et de mise en oeuvre préféré qui va maintenant être décrit, en faisant référence aux dessins annexés parmi lesquels :

- les figures 1 et 2 illustrent schématiquement deux dispositifs de l'art antérieur qui ont été décrits ci-dessus,
- la figure 3 est une représentation schématique d'un dispositif selon l'invention selon un premier mode de réalisation,
- la figure 4 est une représentation schématique d'un dispositif selon l'invention selon un second mode de réalisation,
- la figure 5 montre un dispositif selon l'invention vu en perspective,
- la figure 6 illustre le dispositif de la figure 5 en vue de coupe,
- et les figures 7a à 7c illustrent d'autres modes de réalisation d'une électrode émettrice du dispositif selon l'invention.

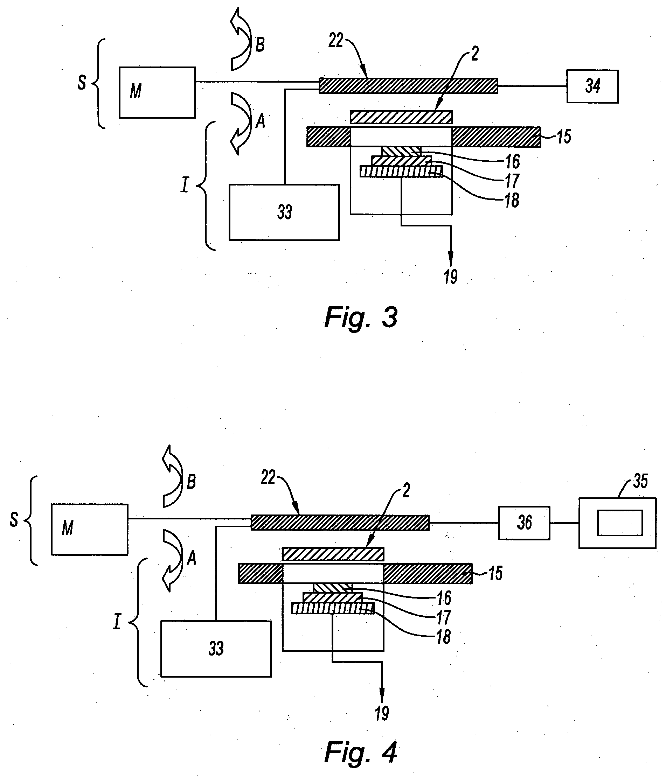

Un premier mode de réalisation est maintenant décrit en faisant référence à la figure 3.

Le dispositif illustré en figure 3 comporte deux parties : une partie supérieure S et une partie inférieure I. La partie supérieure S est montée mobile entre une position d'analyse, illustrée par la flèche portant la référence A, où elle fait face à la partie fixe, et une position d'irradiation, illustrée par la flèche portant la référence B, où elle est éloignée de la partie fixe.

Le dispositif selon ce mode de réalisation est équipé de moyens motorisés M pour faire passer la partie mobile de la position A à la position B, ou inversement.

La partie inférieure du dispositif est connue en soit et constitue un module de détection et de traitement de signal. Elle comporte une électrode de détection (ou de réception) 15, reliée à un capteur piézoélectrique 16, ce dernier étant lui-même relié à un filtre 17 et à un amplificateur 18. La sortie de l'amplificateur est relié à un oscilloscope 19 permettant de visualiser un signal électrique, et notamment le signal électrique issu de l'onde acoustique susceptible d'être générée par le déplacement de charges stockées dans un élément et dont on souhaite connaître la répartition.

L'électrode de détection 15 est avantageusement réalisée en aluminium, pour ses qualités de conducteur électrique, et présente une surface suffisamment grande pour supporter un élément à analyser 2. On prévoit de maintenir l'élément à analyser 2 sur l'électrode 15 par une couche de colle conductrice ou non.

La partie mobile du dispositif représentée sur la figure 3 constitue un module de génération et d'émission d'impulsions. Cette partie est nouvelle au regard des dispositifs de l'état de la technique, et a été mise au point pour transmettre à l'élément/échantillon 2 à analyser l'impulsion nécessaire à la génération d'une onde acoustique caractéristique des charges que l'élément 2 comporte, sans toutefois dégrader l'élément 2 et permettant une précision quant à la quantité de charges détectées et à leur implantation dans l'élément 2.

La partie mobile supérieure S comporte une électrode émettrice 22 dont l'une des extrémités est reliée à un générateur d'impulsion 33, et dont l'autre extrémité est relié à un circuit 34 dont l'impédance est égale la sienne.

Dans le cadre du présent exemple de réalisation, l'impédance de l'électrode émettrice 22 est fixée à 50 Ω. Le circuit 34 présente donc également une impédance à 50 Ω. La présence de ce circuit 34 permet d'éviter le retour de signal ou d'impulsion, ce qui compliquerait l'analyse du signal électrique en sortie du capteur piézoélectrique 16 qui serait représentatif de deux ondes acoustiques générées par les charges : la première onde correspondant à un premier mouvement des charges en réponse à la première impulsion, et la seconde onde correspondant à un second mouvement des charges en réponse à un retour d'impulsion.

Dans une variante de réalisation illustrée en figure 4, le circuit 34 est remplacé par un oscilloscope 35 et un dispositif atténuateur de signal 36 disposé en amont de l'oscilloscope 35. Un tel montage permet également d'éviter le retour d'impulsion ou de signal.

Quand la partie supérieure mobile est placée en position d'analyse A, il existe un espace d'air (ou de vide) entre l'électrode émettrice 22 et la surface de l'élément à analyser 2. Cet espace d'air constitue un diélectrique entre l'électrode émettrice 22 et l'élément à analyser 2.

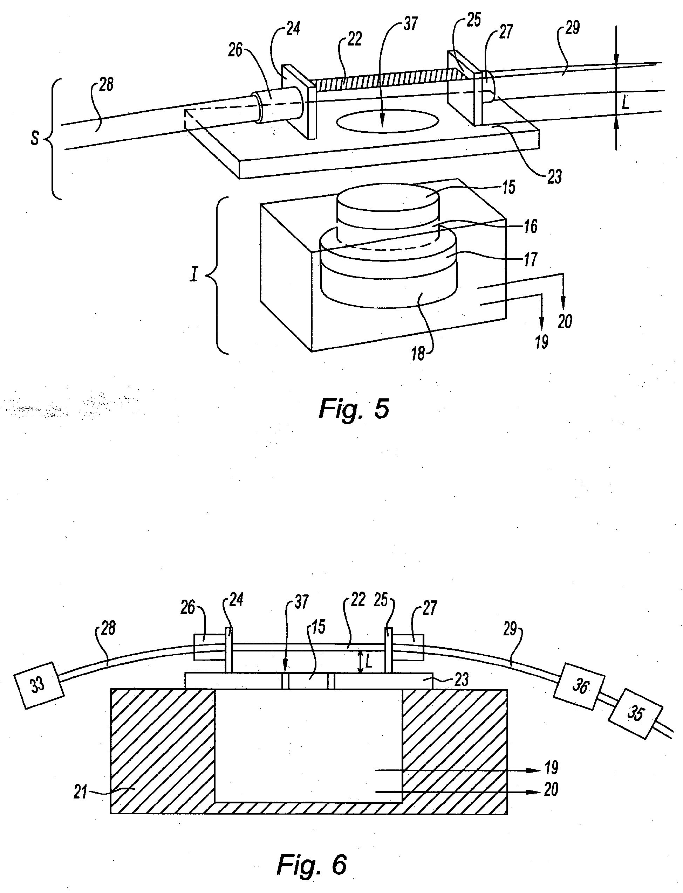

On va maintenant faire référence à la figure 5 pour décrire plus en détails les éléments constituant la partie mobile du dispositif selon l'invention.

L'électrode émettrice 22 est réalisée par une ligne micro ruban.

Cette ligne micro ruban 22 est maintenue à une distance L d'une plaque 23 par des moyens 24 et 25 qui seront définis plus loin.

La plaque 23 présente une lumière traversante 37 livrant passage à l'électrode réceptrice 15 quand la partie mobile supérieure S est en position d'analyse. Dans cette position d'analyse A, la face inférieure de la plaque 23 vient en appui contre une face supérieure d'un boîtier comportant tous les éléments de la partie inférieure I du dispositif, duquel l'électrode réceptrice 15 fait saillie.

Comme on peut le voir en particulier sur la figure 6, quand la partie supérieure S est en position d'analyse, l'électrode réceptrice 15 se trouve dans la lumière traversante 37 et sa partie supérieure affleure le niveau de la face supérieure de la plaque 23, de sorte à constituer un support plat pour l'élément à analyser 2.

La ligne micro ruban 22 est reliée d'une part au générateur d'impulsion 33 au moyen d'un câble coaxial 28, et d'autre part au circuit 34 (ou au dispositif atténuateur 36 dans le cadre de l'exemple représenté en figure 2) par un second câble coaxial 29.

Chacun des câbles coaxiaux 28 et 29 se termine au voisinage de la ligne micro ruban par un connecteur 26 et 27, respectivement, présentant chacun une patte 24 et 25, respectivement, à chacune desquelles est fixée une extrémité de la ligne micro ruban 22.

Les connecteurs 26 et 27 équipés de leur patte 24 et 25 respectivement, assurent d'une part une connexion entre une extrémité de l'électrode émettrice 22 et l'âme du câble coaxiale transmettant l'impulsion ou un signal électrique et d'autre part, une connexion entre le diélectrique et la masse de la partie supérieure S du dispositif selon l'invention, la masse étant constituée par la plaque 23.

On va maintenant s'intéresser à la détermination des caractéristiques de la ligne micro ruban, des impulsions et des divers autres éléments du dispositif conduisant à générer un effet de ligne entre l'électrode émettrice 22 et l'élément 2 dont on cherche à déterminer la répartition des charges qu'il comporte.

Pour déterminer les caractéristiques de la ligne micro ruban 22, il faut tenir compte de la nature du matériau de l'élément à analyser 2 et de l'impédance des éléments à disposition. Notamment, il faut tenir compte de l'impédance du câble coaxial 28 et de la bande de fréquence de ladite impulsion.

A une bande de fréquences allant jusqu'à 1 GHz, correspond une impédance constante équivalente de 50 Ω au niveau de l'électrode émettrice 22. Cette impédance correspond également à celle des câbles coaxiaux 28 et 29.

La demanderesse a donc réalisé une ligne micro ruban d'impédance 50 Ω de manière à ne pas déformer le signal ou l'impulsion transmise à l'élément à analyser 2.

Une ligne micro ruban est constituée d'un ruban conducteur placé sur une face d'un matériau diélectrique dont l'autre face constitue un plan de masse. Une telle ligne de transmission est le siège d'une onde se propageant en mode quasi- TEM (Transverse Electro-Magnétique), c'est-à-dire que les champs électriques et magnétiques sont perpendiculaires à l'axe de la ligne selon lequel s'effectue la propagation. L'impédance caractéristique d'une telle ligne dépend de ses dimensions et de la nature du matériau diélectrique.

Si W est la largeur du ruban (ou piste conductrice) de la ligne micro ruban, et h l'épaisseur du matériau diélectrique sur laquelle le ruban (ou la piste) est placé. Le calcul du rapport W/h correspondant à une impédance $Z_o$ fixée, est donnée par la formule suivante :

pour W/h > 2 :

$$\frac{W}{h} = \frac{2}{\pi}\left\{B-1-\ln(2B-1)+\frac{\varepsilon_r+1}{2\varepsilon_r}\left[\ln(B-1)+0,39-\frac{0,61}{\varepsilon_r}\right]\right\}$$

avec

$$B = \frac{377\pi}{2Z_0\sqrt{\varepsilon_r}}$$

et avec :

$Z_0$     impédance caractéristique de la ligne
W     largeur de la piste
t     épaisseur de la piste
h     épaisseur du diélectrique
$\varepsilon_r$     Constante diélectrique du matériau isolant (permittivité relative)

Dans le cadre du présent exemple, le matériau diélectrique est de l'air, de manière à pouvoir mettre en oeuvre le dispositif dans des conditions simples.

Pour une impédance de 50 Ω, on trouve que la ligne micro ruban peut présenter une largeur de 15,8 mm, et être disposée à une hauteur (référence L sur les figures) au moins égale à 2,5 mm.

Dans un cadre de mise en oeuvre de ce dispositif, l'épaisseur de l'échantillon, dont on doit déterminer la répartition de charges, est sensiblement comprise entre 0 et 500 micromètres.

Il convient toutefois de noter que l'électrode émettrice 22 pourrait être réalisée différemment d'une ligne micro ruban.

L'électrode émettrice 22 pourrait être réalisée à partir d'un élément métallique qui, placé en regard d'une référence de masse (l'élément 2 diélectrique à analyser), forme une capacité et dont la longueur se traduit par une inductance. Comme indiqué précédemment, la racine carrée du rapport inductance sur capacité donne la valeur de l'impédance caractéristique telle qu'elle permet une propagation de signal à faible perte, qui se traduit par un effet appelé effet de ligne.

L'absence de perte est due à la petite dimension du dispositif et de l'élément à analyser 2 face aux différentes longueurs d'ondes du signal qui s'y propage, empêchant le signal de rayonner.

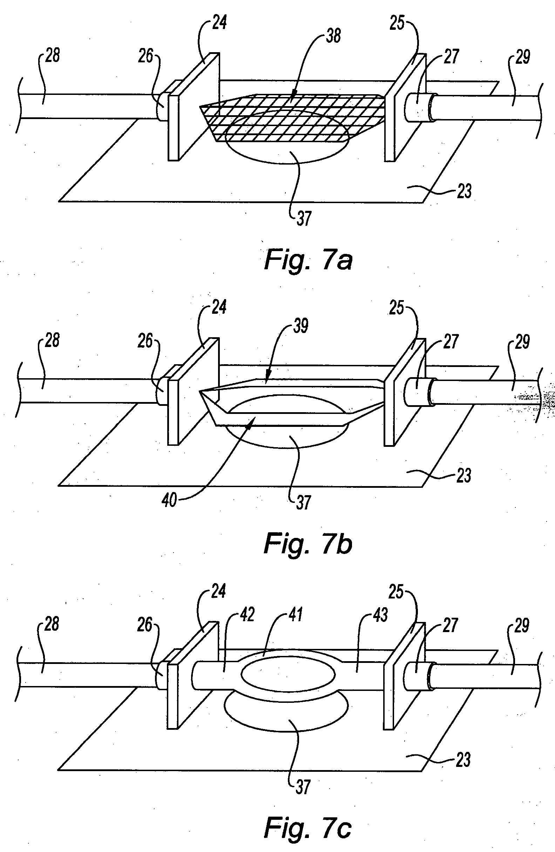

D'autres formes d'électrodes émettrices sont donc envisageables, notamment celles illustrées par les figures 7a à 7c, représentant respectivement une électrode émettrice :

- en forme de grille 38,
- en forme de deux bras symétriques 39 et 40 se joignant par leurs extrémités,
- et en forme d'anneau 41 maintenu entre deux bras 42 et 43.

On va maintenant décrire un procédé pour déterminer une répartition de charges dans un élément 2 réalisé dans un matériau diélectrique selon l'invention.

L'élément 2 est placé sur l'électrode détectrice (ou de réception) 15 et y est collée.

On procède dans un premier temps à l'irradiation de l'élément 2.

Pour ce faire, on bascule le module mobile supérieur S du dispositif selon l'invention en position d'irradiation B. Puis, on place le module fixe inférieur I dans un plasma reproduisant un environnement spatial.

Les charges contenues dans le plasma s'accumulent en surface de l'élément 2, et pénètrent dans son épaisseur.

Après un certain lapse de temps, l'élément à analyser 2 n'est plus soumis à aucune irradiation et on bascule le module mobile S en position d'analyse A.

On émet alors une impulsion à partir du générateur d'impulsion 33.

Cette impulsion est émise par l'électrode émettrice 22 à distance de l'élément à analyser 2, par effet de ligne au travers d'une couche d'air (ou de vide) séparant l'électrode émettrice 22 de l'élément à analyser 2.

En traversant l'élément à analyser 2, l'impulsion entraîne un déplacement des charges, et ce déplacement génère une onde acoustique.

L'onde acoustique est détectée par l'électrode de réception 15 (ou de détection), et transformée en signal électrique par le capteur piézo-électrique 16.

De manière avantageuse, on contrôle l'impulsion au moyen d'un oscilloscope connecté à l'une des extrémités de l'électrode sans contact 22, l'autre extrémité de l'électrode 22 étant reliée au générateur d'impulsion 33. On atténue l'amplitude de l'impulsion en amont de l'oscilloscope de manière à ce que l'impulsion puisse être visible sur l'oscilloscope.

On prévoit que l'impulsion émise soit du type tension en créneaux, par exemple de front de montée égal à 1,2 ns et d'une durée comprise entre 15 et 20 ns.

On détermine alors la répartition des charges stockées dans l'élément 2 à partir des caractéristiques du signal électrique et des données constantes connues.

**Revendications**

1. Dispositif pour déterminer une répartition de charges stockées dans un élément (2) réalisé en matériau diélectrique, ledit dispositif comprenant :

   - une électrode émettrice (22) d'une impulsion apte à générer une onde acoustique par déplacement desdites charges stockées dans ledit élément (2), ladite électrode émettrice étant reliée à un générateur de ladite impulsion (33),
   - et une électrode réceptrice (15) connectée audit élément (2) et équipée d'un capteur (16) apte à détecter ladite onde acoustique et à la transformer en signal électrique, de sorte à déterminer la répartition des charges stockées dans ledit élément (2) à partir dudit signal électrique,
   **caractérisé en ce que** l'électrode émettrice (22) est une électrode sans contact avec ledit élément (2) stockant lesdites charges, apte à transmettre ladite impulsion audit élément (2) à travers un diélectrique séparant ladite électrode émettrice (22) dudit élément (2), par effet de ligne.

2. Dispositif selon la revendication 1, **caractérisé en ce que** ladite électrode sans contact (22) est une ligne micro ruban.

3. Dispositif selon la revendication 2, **caractérisé en ce que** la ligne micro ruban (22) présente une impédance sensiblement égale à 50 Ω.

4. Dispositif selon l'une quelconque des revendications précédentes, **caractérisé en ce que** l'électrode émettrice (22) est montée amovible.

5. Dispositif selon l'une quelconque des revendications précédentes, **caractérisé en ce que** ladite électrode émettrice (22) est fixée à un dispositif de maintien à distance dudit élément (2).

6. Dispositif selon l'une quelconque des revendications précédentes, **caractérisé en ce que** l'électrode émettrice (22) est reliée à l'une de ses extrémités audit générateur d'impulsion (33) et de l'autre de ses extrémités à une charge dont l'impédance est égale à la sienne.

7. Procédé de détermination d'une répartition de charges stockées dans un élément (2) réalisé en matériau diélectrique, ledit procédé comportant les étapes suivantes :

   - émission d'une impulsion électrique apte à générer une onde acoustique par déplacement desdites charges stockées dans ledit élément (2) au moyen d'une électrode émettrice (22) reliée à un générateur d'impulsion (33),
   - détection de ladite onde acoustique au moyen d'une électrode de réception (15),
   - transformation de ladite onde acoustique en signal électrique au moyen d'un capteur piézoélectrique (16) relié à l'électrode de réception,
   - détermination de la répartition des charges stockées dans ledit élément (2) à partir du signal électrique,

   **caractérisé en ce que** ladite étape d'émission est réalisée à distance dudit élément (2), par effet de ligne, au moyen d'une électrode sans contact (22) avec ledit élément (2) stockant lesdites charges, constituant ladite électrode émettrice, un diélectrique séparant ladite électrode sans contact (22) dudit élément (2).

8. Procédé selon la revendication 7, **caractérisé en ce que** l'électrode sans contact (22) présente une impédance sensiblement égale à 50 Ω.

9. Procédé selon l'une quelconque des revendications 7 et 8, **caractérisé en ce que** le diélectrique est de l'air.

10. Procédé selon l'une quelconque des revendications 7 à 9, **caractérisé en ce que** l'on applique une charge égale à la charge de ladite électrode sans contact (22) à une extrémité de l'électrode sans contact (22), l'autre extrémité de l'électrode sans contact (22) étant reliée au générateur d'impulsion (33).

11. Procédé selon l'une quelconque des revendications 7 à 9, **caractérisé en ce que** l'on contrôle ladite impulsion au moyen d'un oscilloscope connecté à l'une des extrémités de l'électrode sans contact (22), l'autre extrémité de l'électrode sans contact (22) étant reliée au générateur d'impulsion (33).

12. Procédé selon la revendication 11, **caractérisé en ce que** l'on atténue l'amplitude de l'impulsion en amont de l'oscilloscope.

13. Procédé selon l'une quelconque des revendications 7 à 12, **caractérisé en ce que** l'on réalise une irradiation du matériau avant l'étape d'émission de l'impulsion.

**Patentansprüche**

1. Vorrichtung zum Ermitteln einer Verteilung von Ladungen, die in einem Element (2) gespeichert sind, das aus einem dielektrischen Material realisiert ist, wobei die Vorrichtung aufweist:

   - eine Elektrode zum Senden (22) eines Impulses, der in der Lage ist eine akustische Welle zu erzeugen durch Verlagerung der besagten Ladungen, die in dem besagten Element (2) gespeichert sind, wobei die Elektrode zum Senden mit einem Generator des besagten Impulses (33) verbunden ist,
   - und eine Empfangselektrode (15), die mit dem besagten Element (2) verbunden ist und mit einem Sensor (16) ausgestattet ist, der in der Lage ist die besagte akustische Welle zu detektieren und diese in ein elektrischen Signal zu transformieren, um die Verteilung der Ladungen, die in dem besagten Element (2) gespeichert sind, ausgehend von dem besagten elektrischen Signal zu ermitteln,

   **dadurch gekennzeichnet, dass** die Elektrode zum Senden (22) eine Elektrode ohne Kontakt mit dem besagten Element (2) ist, welches die besagten Ladungen speichert, die in der Lage ist, den besagten Impuls auf das besagte Element (2) zu übertragen durch ein Dielektrikum, das die besagte Elektrode zum Senden (22) von dem besagten Element (2) separiert, via Leitungseffekt.

2. Vorrichtung gemäß Anspruch 1, **dadurch gekennzeichnet, dass** die besagte Elektrode ohne Kontakt (22) ein Mikrobandleitung ist.

3. Vorrichtung gemäß Anspruch 2, **dadurch gekennzeichnet, dass** die Mikrobandleitung (22) eine Impedanz von im Wesentlichen gleich $50\Omega$ hat.

4. Vorrichtung gemäß irgendeinem der vorhergehenden Ansprüche, **dadurch gekennzeichnet, dass** die Elektrode zum Senden (22) abnehmbar angebracht ist.

5. Vorrichtung gemäß irgendeinem der vorhergehenden Ansprüche, **dadurch gekennzeichnet, dass** die besagte Elektrode zum Senden (22) an einer Vorrichtung zum Halten im Abstand von dem Element (2) fixiert ist.

6. Vorrichtung gemäß irgendeinem der vorhergehenden Ansprüche, **dadurch gekennzeichnet, dass** die Elektrode zum Senden (22) mit einem ihrer Enden mit dem besagten Impuls-Generator (33) und mit dem anderen ihrer Enden mit einer Ladung verbunden ist, deren Impedanz gleich der ihren ist.

7. Verfahren zur Ermittlung einer Verteilung von Ladungen, die in einem Element (2) gespeichert sind, das aus einem dielektrischen Material ist, wobei das Verfahren die nachfolgenden Schritte aufweist:

   - Senden eines elektrischen Impulses, der in der Lage ist eine akustische Welle zu erzeugen durch Verlagerung der besagten Ladungen, die in dem besagten Element (2) gespeichert sind, mittels einer Sendeelektrode (22), die mit einem Impulsgenerator (33) verbunden ist,
   - Erfassen der besagten akustischen Welle mittels einer Empfangselektrode (15),
   - Transformieren der besagten akustischen Welle in ein elektrisches Signal mittels eines piezoelektrischen Sensors (16), der mit der Empfangselektrode verbunden ist,

- Ermitteln der Verteilung der Ladungen, die in dem besagten Element (2) gespeichert sind, ausgehend von dem elektrischen Signal,

**dadurch gekennzeichnet, dass** der Schritt des Sendes realisiert wird im Abstand von dem besagten Element (2) durch Leitungseffekt mittels einer Elektrode ohne Kontakt (22) mit dem besagten Element (2), das die besagten Ladungen speichert, welche die besagte Sendeelektrode bildet, wobei ein Dielektrikum die besagte Elektrode ohne Kontakt (22) von dem besagten Element (2) separiert.

8. Verfahren gemäß Anspruch 7, **dadurch gekennzeichnet, dass** die Elektrode ohne Kontakt (22) eine Impedanz von im Wesentlichen gleich 50Ω hat.

9. Verfahren gemäß irgendeinem der Ansprüche 7 und 8, **dadurch gekennzeichnet, dass** das Dielektrikum Luft ist.

10. Verfahren gemäß irgendeinem der Ansprüche 7 bis 9, **dadurch gekennzeichnet, dass** man eine Ladung, die gleich der Ladung der besagten Elektrode ohne Kontakt (22) ist, an einem Ende der Elektrode ohne Kontakt (22) aufbringt, wobei das andere Ende der Elektrode ohne Kontakt (22) mit dem Impuls-Generator (33) verbunden ist.

11. Verfahren gemäß irgendeinem der Ansprüche 7 bis 9, **dadurch gekennzeichnet, dass** man den besagten Impuls steuert mittels eines Oszilloskops, das mit einem der Enden der Elektrode ohne Kontakt (22) verbunden ist, wobei das andere Ende der Elektrode ohne Kontakt (22) mit dem Impuls-Generator (33) verbunden ist.

12. Verfahren gemäß Anspruch 11, **dadurch gekennzeichnet, dass** man die Amplitude des Impulses vor dem Oszilloskop abschwächt.

13. Verfahren gemäß irgendeinem der Ansprüche 7 bis 12, **dadurch gekennzeichnet, dass** man eine Bestrahlung des Materials vor dem Schritt des Sendens des Impulses realisiert.

## Claims

1. Device for determining a distribution of charges stored in an element (2) made of dielectric material, said device comprising:

   - an electrode (22) for transmitting a pulse capable of generating an acoustic wave by displacing said charges stored in said element (2), said transmitting electrode being connected to a generator of said pulse (33),
   - and a receiving electrode (15) which is connected to said element (2) and is equipped with a sensor (16) capable of detecting said acoustic wave and converting it into an electrical signal, so as to determine the distribution of the charges stored in said element (2) from said electrical signal,

   **characterised in that** the transmitting electrode (22) is an electrode which is not in contact with said element (2) storing said charges and which is capable of transmitting said pulse to said element (2) through a dielectric separating said transmitting electrode (22) from said element (2), by the line effect.

2. Device according to claim 1, **characterised in that** said contactless electrode (22) is a microstrip line.

3. Device according to claim 2, **characterised in that** the microstrip line (22) has an impedance substantially equal to 50 Ω.

4. Device according to any one of the preceding claims, **characterised in that** the transmitting electrode (22) is removably mounted.

5. Device according to any one of the preceding claims, **characterised in that** said transmitting electrode (22) is fixed to a device for maintaining a distance from said element (2).

6. Device according to any one of the preceding claims, **characterised in that** the transmitting electrode (22) is connected at one of its ends to said pulse generator (22) and at its other end to a charge whose impedance is equal to its own.

7. Method of determining a distribution of charges stored in an element (2) made of dielectric material, said method comprising the following steps:

- transmitting an electric pulse capable of generating an acoustic wave by displacing said charges stored in said element (2), by means of a transmitting electrode (22) connected to a pulse generator (33),
- detecting said acoustic wave by means of a receiving electrode (15),
- converting said acoustic wave into an electrical signal by means of a piezoelectric sensor (16) connected to the receiving electrode,
- determining the distribution of the charges stored in said element (2) from the electrical signal,

**characterised in that** said transmitting step is carried out at a distance from said element (2), by the line effect, by means of an electrode (22) which is not in contact with said element (2) storing the charges and which constitutes said transmitting electrode, a dielectric separating said contactless electrode (22) from said element.

8. Method according to claim 7, **characterised in that** the contactless electrode (22) has an impedance substantially equal to 50 Ω.

9. Method according to either claim 7 or claim 8, **characterised in that** the dielectric is air.

10. Method according to any one of claims 7 to 9, **characterised in that** a charge equal to the charge of said contactless electrode (22) is applied to one end of the contactless electrode (22), the other end of the contactless electrode (22) being connected to the pulse generator (33).

11. Method according to any one of claims 7 to 9, **characterised in that** said pulse is controlled by means of an oscilloscope connected to one of the ends of the contactless electrode (22), the other end of the contactless electrode (22) being connected to the pulse generator (33).

12. Method according to claim 11, **characterised in that** the amplitude of the pulse is attenuated upstream of the oscilloscope.

13. Method according to any one of claims 7 to 12, **characterised in that** the material is irradiated prior to the step of transmitting the pulse.

Art antérieur                    Fig. 1

Art antérieur                    Fig. 2

**Fig. 3**

**Fig. 4**

EP 2 158 494 B1

Fig. 5

Fig. 6

Fig. 7a

Fig. 7b

Fig. 7c

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- INNOVATIVE PEA SPACE CHARGE MEASURE-MENT SYSTEMS FOR INDUSTRIAL APPLICA-TIONS. *IEEE Electrical Insulation Magazine,* Mars 2004, vol. 20 (2